# EUROPEAN PATENT APPLICATION

(11) **EP 3 399 547 A1**
(43) Date of publication of application: **07.11.2018**
(21) Application number: 16881112.3
(22) Date of filing: 24.12.2016
(51) Int. Cl.: H01L 23/485, H01L 23/49

(54) **PACKAGING STRUCTURE, ELECTRONIC DEVICE AND PACKAGING METHOD**

(30) Priority: 31.12.2015 CN 201511030490
(71) Applicant: Huawei Technologies Co., Ltd., Longgang District Shenzhen, Guangdong 518129 (CN)
(72) Inventor: ZHAO, Nan, Shenzhen Guangdong 518129 (CN); XIE, Wenxu, Shenzhen Guangdong 518129 (CN); ZHANG, Xiaodong, Shenzhen Guangdong 518129 (CN); FU, HuiLi, Shenzhen Guangdong 518129 (CN)
(74) Representative: Thun, Clemens
(86) International application number: PCT/CN2016/111924
(87) International publication number: WO 2017/114323

(57) **Abstract**

The present invention discloses a packaging structure, including a substrate, a fan-out unit, and a wiring layer. The fan-out unit includes a first chip and a second chip. The first chip includes a first pin array, and the second chip includes a second pin array. The fan-out unit further includes a third pin array. The first pin array, the second pin array, and the third pin array are all disposed facing the substrate. The wiring layer bridges over between the first pin array and the second pin array, and is configured to connect each first pin in the first pin array to a corresponding second pin in the second pin array. The substrate is provided with a soldering pad that is electrically connected to a wiring layer in the substrate, and the third pin array is connected to the soldering pad. The present invention further discloses an electronic device and a packaging method. The packaging structure in the present invention has advantages of a low process difficulty, low costs, and miniaturization.

## Description

This application claims priority to Chinese Patent Application No. 201511030490.0, filed with the Chinese Patent Office on December 31, 2015 and entitled "PACKAGING STRUCTURE, ELECTRONIC DEVICE, AND PACKAGING METHOD", which is incorporated herein by reference in its entirety.

### TECHNICAL FIELD

The present invention relates to the field of microelectronic packaging technologies, and in particular, to a packaging structure and a packaging method.

### BACKGROUND

As an integrated electronic technology develops, a requirement on chip performance continuously increases, such as function enhancement, size reduction, and reduction of energy consumption and costs. Therefore, a 3DIC (three-dimensional integrated circuit) technology and a 2.5D IC packaging technology have emerged. A silicon interposer (Silicon Interposer) technology is a technical solution for implementing interconnection between dies (Die) and interconnection between a die and a substrate in the three-dimensional integrated circuit technology and the 2.5D IC packaging technology.

2.5D IC packaging is used as an example. In the 2.5D IC packaging in the prior art, at least two dies are integrated into a fan-out unit (Fan out Unit) by using a fan-out wafer level package technology, and the fan-out unit is packaged on a substrate by using a silicon interposer. Both interconnection between the at least two dies and interconnection between a die and a substrate are implemented by using the silicon interposer. In a solution based on the silicon interposer technology, an interconnection line whose line width and node spacing are much less than those of a resin substrate is fabricated on a silicon chip by using a semiconductor process. Therefore, chips with different functions (for example, a CPU (central processing unit) and a DRAM (dynamic random access memory)) may be connected to a same silicon interposer, and complete massive operations and data exchange by using the silicon interposer. The silicon interposer implements wiring by using a through silicon via (TSV, through silicon via) technology. However, a through silicon via fabrication process is a deep reactive ion etching (DRIE) technology; and in a through silicon via filling process, a seed layer is first generated on a surface of a through silicon via by using a physical vapor deposition (PVD) technology, and then the process is completed by means of electroplating.

It can be learned that a 2.5D IC packaging implementation solution in the prior art has disadvantages of a high process difficulty and high production costs. In addition, a size of the silicon interposer is greater than a sum of sizes of all dies. A large-size silicon interposer leads to high consumption (that is, high costs). Consequently, 2.5D IC packaging costs further increase. This is not conducive to miniaturization of a packaging structure.

### SUMMARY

The present invention provides a packaging structure featuring a low process difficulty, low costs, and miniaturization, and an electronic device having the packaging structure. The present invention further provides a packaging method for fabricating the packaging structure.

To achieve the foregoing objective, implementations of the present invention provide the following technical solutions:

According to a first aspect, the present invention provides a packaging structure, including a substrate, a fan-out unit, and a wiring layer, where the fan-out unit includes a first chip and a second chip, the first chip includes a first pin array, the second chip includes a second pin array, the fan-out unit further includes a third pin array, the first pin array, the second pin array, and the third pin array are all disposed facing the substrate, the first pin array includes multiple first pins, the second pin array includes multiple second pins, and the third pin array includes multiple third pins; the wiring layer bridges over between the first pin array and the second pin array, and is configured to connect each first pin in the first pin array to a corresponding second pin in the second pin array, so as to implement electrical connection between the first chip and the second chip; and the substrate is provided with a soldering pad that is electrically connected to a wiring layer in the substrate, and the third pins are connected to the soldering pad, so as to implement electrical connection between the fan-out unit and the substrate. In a specific implementation, the first chip may be a storage chip, a 3D laminated chip module, a silicon die, a flip chip packaging structure, or a passive element. The second chip and the first chip may be of a same type, or may be of different types. Each third pin in the third pin array is columnar or spherical, and a material of the third pin is copper, tin, or lead.

In a preferred implementation, the first chip and the second chip are adjacently disposed, the first pin array and the second pin array are adjacently disposed, and the third pin array is located in an area, other than the first pin array and the second pin array, in the fan-out unit.

Beneficial effects of the packaging structure in the present invention are as follows: The wiring layer bridges over between the first pin array and the second pin array, and is configured to connect the first pins in the first pin array to the corresponding second pins in the second pin array, so as to implement the electrical connection between the first chip and the second chip without a need of disposing an intermediate board with a through-via structure. In addition, because it is easy to fabricate the wiring layer (which may be implemented by using an ordinary layer-adding process), costs are low. In addition, the third pin array is directly connected to the substrate, so that the fan-out unit is connected to the substrate without a need of disposing an intermediate board with a large area, and a process for fabricating a through via on an intermediate board is not required (in the prior art, wiring of the electrical connection between the fan-out unit and the substrate is implemented by using a through silicon via (TSV, through silicon via) technology based on a silicon interposer, and this leads to a high process difficulty and high costs). Therefore, the present invention has advantages of a low process difficulty and low costs. On this basis, a wiring structure of the electrical connection between the fan-out unit and the substrate in the present invention is also conducive to a miniaturization design of a packaging structure.

With reference to the first aspect, in a first possible implementation, the packaging structure further includes an intermediate board disposed between the fan-out unit and the substrate, and the wiring layer is formed on a surface of the intermediate board. The wiring layer is disposed on the intermediate board, and then the intermediate board is installed on the fan-out unit. Therefore, it is easy to implement a fabrication process.

With reference to the first possible implementation of the first aspect, in a second possible implementation, a material of the intermediate board is silicon, glass, or an organic substrate.

With reference to the first possible implementation of the first aspect, in a third possible implementation, the intermediate board and the substrate are isolated from each other. This isolation architecture increases signal isolation of wiring on the wiring layer, thereby facilitating high-density signal transmission. In another implementation, an insulation layer may be disposed between the intermediate board and the substrate to form a laminated contact architecture, and a size of the laminated contact architecture may be minimized.

With reference to the first aspect, in a fourth possible implementation, the wiring layer is formed on surfaces that are of the first pin array and the second pin array and that face the substrate. In this implementation, the wiring layer is directly disposed on the fan-out unit, so that a quantity of elements with a packaging structure is simplified (without using the intermediate board), and a size may also be minimized.

With reference to the first aspect, in a fifth possible implementation, the wiring layer includes a first circuit layer, a reference layer, and a second circuit layer that are sequentially laminated, and the reference layer is a reference plane for the first circuit layer and the second circuit layer. Disposing the reference plane helps improve signal quality and reduce signal crosstalk.

With reference to the first aspect, in a sixth possible implementation, a surface of the first chip and a surface of the second chip form a heat sink surface of the fan-out unit, and the heat sink surface is located on a surface that is of the fan-out unit and that is far away from the substrate. The packaging structure in this implementation has good heat dissipation performance, so that a service life and operation stability of the packaging structure can be improved.

With reference to the sixth possible implementation of the first aspect, in a seventh possible implementation, the packaging structure further includes a heat sink fin, the heat sink fin shields the fan-out unit on the substrate, and the heat sink fin is in contact with the heat sink surface. A design of the heat sink fin further improves the heat dissipation performance, the service life, and the operation stability of the packaging structure.

With reference to the sixth possible implementation of the first aspect, in an eighth possible implementation, the packaging structure further includes a heat sink fin and a thermally conductive adhesive, the heat sink fin shields the fan-out unit on the substrate, and the thermally conductive adhesive is disposed between the heat sink surface and the heat sink fin. The heat sink fin is excellently laminated to the fan-out unit by using the thermally conductive adhesive, thereby enhancing the heat dissipation performance.

According to a second aspect, the present invention provides an electronic device, where the electronic device includes the packaging structure according to any one of the implementations of the first aspect.

According to a third aspect, the present invention provides a packaging method, including:
fabricating a fan-out unit, where the fan-out unit includes a first chip and a second chip, the first chip includes a first pin array, the second chip includes a second pin array, the fan-out unit further includes a third pin array, the first pin array, the second pin array, and the third pin array are all disposed facing the substrate, the first pin array includes multiple first pins, the second pin array includes multiple second pins, and the third pin array includes multiple third pins;
fabricating a wiring layer, where the wiring layer bridges over between the first pin array and the second pin array, and is configured to connect each first pin in the first pin array to a corresponding second pin in the second pin array, so as to implement electrical connection between the first chip and the second chip; and
connecting the third pin array to the substrate, where the substrate is provided with a soldering pad that is electrically connected to a wiring layer in the substrate, and the third pins are connected to the soldering pad, so that the fan-out unit is installed on and electrically connected to the substrate.

Beneficial effects of the packaging method in the present invention are as follows: The wiring layer bridges over between the first pin array and the second pin array, and is configured to connect the first pins in the first pin array to the corresponding second pins in the second pin array, so as to implement the electrical connection between the first chip and the second chip without a need of disposing an intermediate board with a through-via structure. In addition, because it is easy to fabricate the wiring layer (which may be implemented by using an ordinary layer-adding process), costs are low. In addition, the third pin array is directly connected to the substrate, so that the fan-out unit is connected to the substrate without a need of disposing an intermediate board with a large area, and a process for fabricating a through via on an intermediate board is not required (In the prior art, wiring of the electrical connection between the fan-out unit and the substrate is implemented by using a through silicon via (TSV, through silicon via) technology based on a silicon interposer, and this leads to a high process difficulty and high costs.). Therefore, the present invention has advantages of a low process difficulty and low costs. On this basis, a wiring structure of the electrical connection between the fan-out unit and the substrate in the present invention is also conducive to a miniaturization design of the packaging structure.

In a specific implementation, the first chip may be a storage chip, a 3D laminated chip module, a silicon die, a flip chip packaging structure, or a passive element. The second chip and the first chip may be of a same type, or may be of different types. Each third pin in the third pin array is columnar or spherical, and a material of the third pin is copper, tin, or lead.

With reference to the third aspect, in a first possible implementation, the step of fabricating a fan-out unit includes: performing, by using a molding compound, molding packaging on the first chip and the second chip to form the fan-out unit, where a distance between the first chip and the second chip is less than or equal to 50 um, side faces of the first chip and the second chip are wrapped by the molding compound, front sides of the first chip and the second chip form an outer surface of the fan-out unit, and the first pin array and the second pin array are respectively disposed on the front side of the first chip and the front side of the second chip.

Further, both a density of the first pin array and a density of the second pin array are less than a density of the third pin array. In addition, a size of each third pin is greater than a size of each first pin, the size of each third pin is also greater than a size of each second pin, and the size of the first pin may be the same as the size of the second pin.

With reference to the first possible implementation of the third aspect, in a second possible implementation, the step of fabricating a fan-out unit further includes: grinding back sides of the first chip and the second chip of the fan-out unit, so that the back sides of the first chip and the second chip form the outer surface of the fan-out unit, so as to form a heat sink surface of the fan-out unit.

With reference to the second possible implementation of the third aspect, in a third possible implementation, the packaging method further includes: fabricating a heat sink fin; and installing the heat sink fin on the substrate, so that the heat sink fin shields the fan-out unit and is in contact with the heat sink surface.

With reference to the second possible implementation of the third aspect, in a fourth possible implementation, the packaging method further includes: fabricating a heat sink fin, where the heat sink fin is made from a metallic or non-metallic thermally conductive material; coating a thermally conductive adhesive on the heat sink surface; and installing the heat sink fin on the substrate, so that the heat sink fin shields the fan-out unit and is in contact with the thermally conductive adhesive.

With reference to the third aspect, in a fifth possible implementation, the packaging method further includes: providing an intermediate board, where the wiring layer is a circuit layer that is fabricated on a surface of the intermediate board by using a layer-adding process; and laminating the intermediate board to the fan-out unit, so that the wiring layer connects the first pins in the first pin array to the corresponding second pins in the second pin array.

With reference to the third aspect, in a sixth possible implementation, in a process of connecting the third pin array to a substrate, the packaging method further includes a step of adjusting an installation height, where a height difference between the fan-out unit and the substrate is changed by adjusting a size of a connection structure between the third pin array and the substrate.

With reference to the third aspect, in a seventh possible implementation, in the process of connecting the third pin array to a substrate, the packaging method further includes a step of adjusting the installation height, where a groove is disposed on the substrate, and the groove is disposed opposite to the wiring layer, so as to change the height difference between the fan-out unit and the substrate by means of collaboration between the wiring layer and the groove.

### BRIEF DESCRIPTION OF DRAWINGS

To describe the technical solutions in the present invention more clearly, the following briefly describes the accompanying drawings required for describing the implementations. Apparently, the accompanying drawings in the following description show merely some implementations of the present invention, and a person of ordinary skill in the art may still derive other drawings from these accompanying drawings without creative efforts.
FIG. 1 is a schematic diagram of a packaging structure according to a first implementation of the present invention;
FIG. 2 is a schematic diagram of a packaging structure according to a second implementation of the present invention;
FIG. 3 is a schematic diagram of a packaging structure according to a third implementation of the present invention;
FIG. 4 is a schematic diagram of a packaging structure according to a fourth implementation of the present invention;
FIG. 5 is a schematic diagram of wiring at a first layer of a wiring layer of a packaging structure according to an implementation of the present invention, where the packaging structure includes a first pin array, a second pin array, a third pin array, and a soldering pad on a substrate;
FIG. 6 is a schematic diagram of wiring at a third layer of a wiring layer of a packaging structure according to an implementation of the present invention, where the packaging structure includes a first pin array, a second pin array, a third pin array, and a soldering pad on a substrate; and
FIG. 7 is a schematic diagram of a fan-out unit of a packaging structure according to an implementation of the present invention.

### DESCRIPTION OF EMBODIMENTS

The present invention relates to a packaging structure and an electronic device having the packaging structure. The present invention further provides a packaging method for fabricating the packaging structure. The following clearly and completely describes the technical solutions in the implementations of the present invention with reference to the accompanying drawings in the implementations of the present invention.

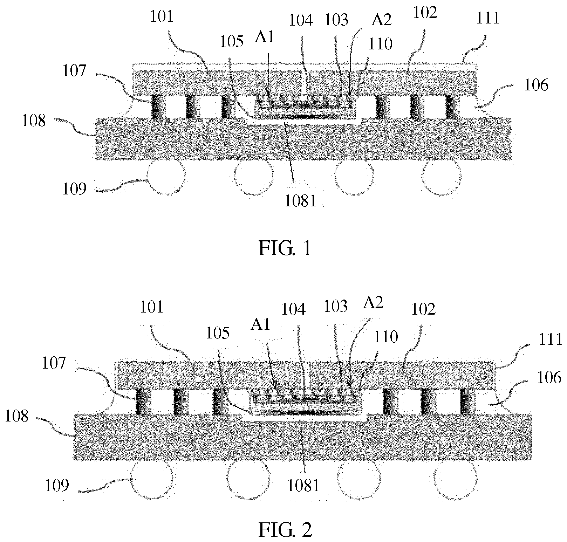

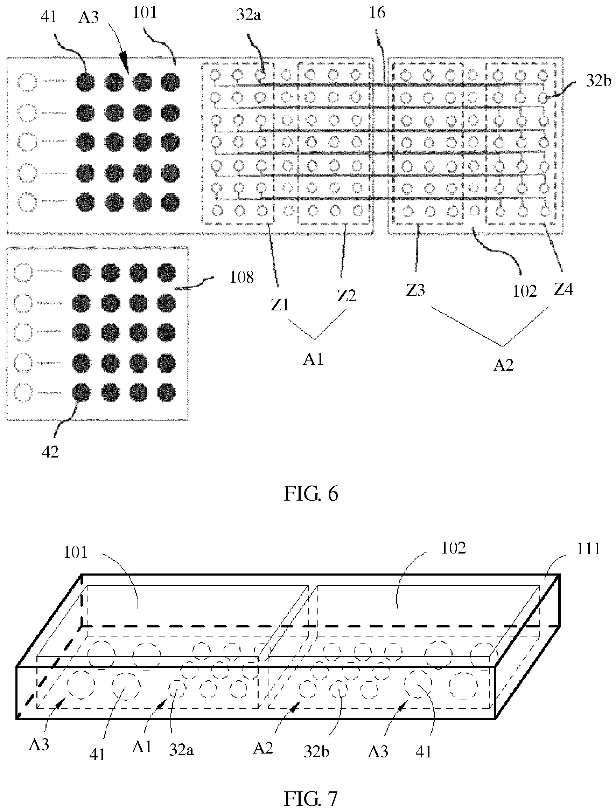

FIG. 1 shows a schematic diagram of a packaging structure according to a first implementation of the present invention. The packaging structure includes a substrate 108, a fan-out unit 111, and a wiring layer 104. The fan-out unit 111 includes a first chip 101 and a second chip 102. Referring to FIG. 7, FIG. 7 illustrates a structure of the fan-out unit 111, and hidden lines (invisible lines in a view direction) are represented by dashed lines. The first chip 101 includes a first pin array A1, and the first pin array A1 includes multiple first pins 32a. The second chip 102 includes a second pin array A2, and the second pin array A2 includes multiple second pins 32b. The fan-out unit 111 further includes a third pin array A3. The first pin array A1, the second pin array A2, and the third pin array A3 are all disposed facing the substrate 108. Surfaces that are of the first chip 101 and the second chip 102 and that face the substrate 108 are defined as front sides, and reverse surfaces are defined as back sides. The first pin array A1, the second pin array A2, and the third pin array A3 are distributed on the front sides of the first chip 101 and the second chip 102. In this implementation, the first chip 101 and the second chip 102 are adjacently disposed, the first pin array A1 and the second pin array A2 are adjacently disposed, and the third pin array A3 is distributed in an area, other than the first pin array A1 and the second pin array A2, in the fan-out unit 111. That the first chip 101 and the second chip 102 are adjacently disposed indicates that the first chip 101 and the second chip 102 are not separated from each other by another chip.

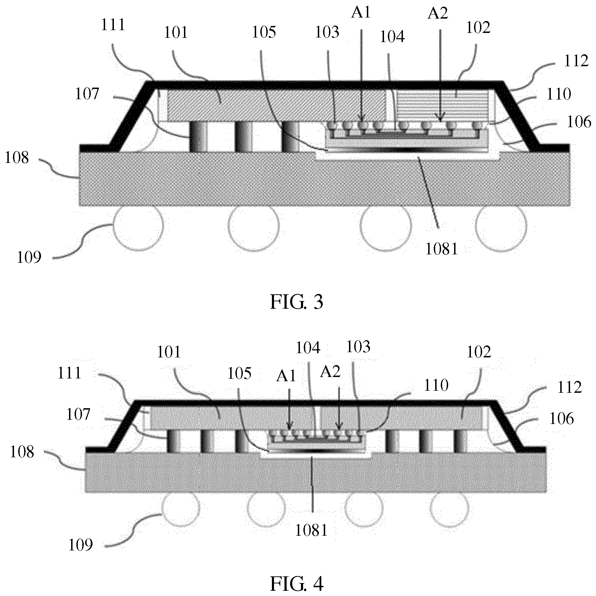

In the implementation shown in FIG. 1, third pin arrays A3 are distributed on both the first chip 101 and the second chip 102. In another implementation, the third pin array A3 may be distributed only on either of the first chip 101 and the second chip 102 (as shown in an embodiment in FIG. 3). That is, referring to FIG. 1, the first chip 101 includes the first pin array A1 and the third pin array A3, and the second chip 102 includes the second pin array A2 and the third pin array A3. The first pin array A1 of the first chip 101 and the second pin array A2 of the second chip 102 are adjacent and located in a central area of the fan-out unit 111. The third pin array A3 of the first chip 101 and the third pin array A3 of the second chip 102 are distributed in an edge area of the fan-out unit 111, and respectively located on two sides of the first pin array A1 and the second pin array A2. In another implementation, as shown in FIG. 3, the first chip 101 includes the first pin array A1 and the third pin array A3, and the second chip 102 includes only the second pin array A2; that is, in the implementation shown in FIG. 3, the third pin array A3 is distributed only on the first chip 101.

The first chip 101 may be a storage chip, a 3D laminated chip module, a silicon die, a flip chip packaging structure, or a passive element. The second chip 102 and the first chip 101 may be of a same type, or may be of different types. In the embodiments shown in FIG. 1 and FIG. 2, the first chip 101 and the second chip 102 are of a same type. In the embodiment shown in FIG. 3, the first chip 101 and the second chip 102 are of different types. For example, the first chip 101 is a silicon die, and the second chip 102 is a 3D laminated chip module. However, the embodiment is not limited to this combination.

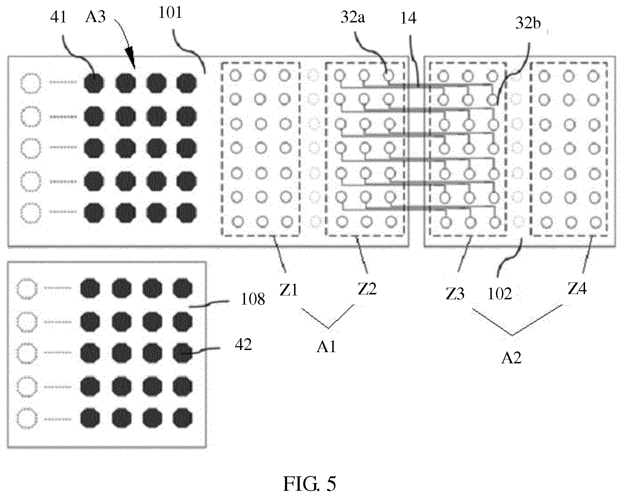

In an implementation, both a density of the first pin array A1 and a density of the second pin array A2 are less than a density of the third pin array A3. Referring to FIG. 5 and FIG. 6, the first pin array A1 includes multiple first pins 32a distributed in an array manner, the second pin array A2 includes multiple second pins 32b distributed in an array manner, and the third pin array A3 includes multiple third pins 41 distributed in an array manner. A size of each third pin 41 is greater than a size of each first pin 32a, the size of each third pin 41 is also greater than a size of each second pin 32b, and the size of the first pin 32a may be the same as the size of the second pin 32b.

Referring to FIG. 1 to FIG. 4, reference signs A1 and A2 in these four figures are indicated by arrow lines. The arrow lines indicate that specific positions at which the first pin array A1 and the second pin array A2 are disposed are on a plane that is indicated by the arrow lines and that is perpendicular to a paper surface. The first pin array A1 and the second pin array A2 are specifically located on a surface of the fan-out unit 111 corresponding to a solder ball 103 (a structure of the solder ball 103 may be a copper cylinder, a solder ball, a lead bump, or the like). The solder ball 103 is configured to connect the wiring layer 104 to the first pin array A1 and the second pin array A2. The third pin array A3 is specifically located on the surface of the fan-out unit 111 corresponding to copper cylinders 107 (a structure of the copper cylinder 107 may also be a copper cylinder, a solder ball, a lead bump, or the like). The copper cylinders 107 are configured to connect the fan-out unit 111 to the substrate 108. To ensure high-density interconnection between the first chip 101 and the second chip 102, a designed distance between the first chip 101 and the second chip 102 needs to be minimized. The distance between the first chip 101 and the second chip 102 is usually less than or equal to 50 um.

The wiring layer 104 bridges over between the first pin array A1 and the second pin array A2, and is configured to connect each first pin 32a in the first pin array A1 to a corresponding second pin 32b in the second pin array A2, so as to implement electrical connection between the first chip 101 and the second chip 102. In an implementation, the wiring layer 104 is connected to the first pin array A1 and the second pin array A2 by using the solder ball 103. The third pin array A3 is connected to the substrate 108, so as to implement electrical connection between the fan-out unit 111 and the substrate 108. In an implementation, the third pin array A3 is connected to the substrate 108 by using the copper cylinders 107. The substrate 108 is provided with a soldering pad 42 that is electrically connected to a wiring layer in the substrate 108 (as shown in FIG. 5 and FIG. 6). In FIG. 1 to FIG. 4, a soldering pad on the substrate 108 is located on a surface of the substrate 108 corresponding to the copper cylinders 107. The third pin array A3 is electrically connected to the soldering pad 42. Specifically, the third pin array A3 is connected to the soldering pad 42 by using the copper cylinders 107.

Referring to FIG. 5, FIG. 6, and FIG. 7, the first pin 32a, the second pin 32b, and the third pin 41 may be, but is not limited to, a spherical structure, a disc-like structure, or a columnar structure, and materials of the first pin 32a, the second pin 32b, and the third pin 41 may be copper, tin, or lead. Shapes and materials of the first pin 32a and the second pin 32b may be the same as or different from a shape and a material of the third pin 41. This is not limited in the present invention. In a preferred implementation, sizes of the first pin 32a and the second pin 32b are less than a size of the third pin 41. In an implementation, that the first pin 32a, the second pin 32b, and the third pin 41 are spherical is used as an example. Diameters of the first pin 32a and the second pin 32b may be less than or equal to 1 um, and a diameter of the third pin 41 may be less than or equal to 10 um. The first pin 32a, the second pin 32b, and the third pin 41 may be flush with a surface of the fan-out unit 111, or may be designed as a convex structure or a concave structure. Structures of the first pin 32a, the second pin 32b, and the third pin 41 are similar to a structure of a soldering pad on a surface of a circuit board.

A sealing adhesive is further filled between the fan-out unit 111 and the substrate 108. The sealing adhesive is coated on the solder ball 103, the copper cylinders 107, and the wiring layer 104 to strengthen the packaging structure. In an implementation, sealing adhesives are filled between the fan-out unit 111 and the substrate 108 twice to complete a packaging process. First, the wiring layer 104 may be packaged to the fan-out unit 111, and a sealing adhesive 110 is filled between the wiring layer 104 and the fan-out unit. Then, the fan-out unit 111 is packaged to the substrate 108 by using a sealing adhesive 106. The sealing adhesive 110 and the sealing adhesive 106 may be made from different materials. Certainly, alternatively, packaging between the fan-out unit 111 and the substrate 108 may be completed in one packaging process.

The wiring layer 104 may be disposed on a separate substrate, and then the substrate is installed on the fan-out unit 111; or the wiring layer 104 may be directly formed on the fan-out unit 111 regardless of whether a carrier of the wiring layer 104 is the fan-out unit 111 or a separate substrate. A process for fabricating the wiring layer 104 may be implemented by using a layer-adding process. This is similar to a method for fabricating a circuit layer on a surface of a circuit board in the prior art, and a process for fabricating a through via is not required. Therefore, it is easy to fabricate the wiring layer 104, and costs are low. Specific implementations are described below. In an implementation, the packaging structure further includes an intermediate board 105 disposed between the fan-out unit 111 and the substrate 108. The wiring layer 104 is formed on a surface of the intermediate board 105, and then the intermediate board 105 is installed on the first pin array A1 and the second pin array A2 of the fan-out unit 111 by using the solder ball 103. A material of the intermediate board 105 is silicon, glass, or an organic substrate 108. The intermediate board 105 and the substrate 108 are isolated from each other. In another implementation, an insulation layer may be disposed between the intermediate board 105 and the substrate 108 to form a laminated contact architecture. In another implementation, the wiring layer 104 is formed on surfaces that are of the first pin array A1 and the second pin array A2 and that face the substrate 108. In this implementation, the solder ball 103 and the intermediate board 105 do not need to be designed.

Referring to FIG. 2, in an implementation shown in FIG. 2, a surface of the first chip 101 and a surface of the second chip 102 form a heat sink surface of the fan-out unit 111, and the heat sink surface is located on a surface that is of the fan-out unit 111 and that is far away from the substrate 108. The formation of heat sink surface facilitates heat dissipation of the packaging structure. For some chips with relatively low power consumption or a low heat dissipation requirement, the first chip 101 and the second chip 102 may be covered by a molding compound on the surface that is of the fan-out unit 111 and that is far away from the substrate 108, that is, as shown in FIG. 1, the first chip 101 and the second chip 102 do not need to be exposed, so as to simplify a fabrication process and reduce processing costs.

Referring to FIG. 3 and FIG. 4, the packaging structure further includes a heat sink fin 112. The heat sink fin 112 shields the fan-out unit 111 on the substrate 108, and the heat sink fin 112 is in contact with the heat sink surface. In another implementation, the packaging structure further includes a heat sink fin 112 and a thermally conductive adhesive. The heat sink fin 112 shields the fan-out unit 111 on the substrate 108, and the thermally conductive adhesive is disposed between the heat sink surface and the heat sink fin 112. The disposing of thermally conductive adhesive facilitates lamination between the heat sink fin 112 and the fan-out unit 111, thereby enhancing a heat dissipation effect. Specifically, the heat sink fin 112 includes a cover body and a side wall. The side wall and the cover body jointly form an accommodation cavity. An end of the side wall is connected to the cover body, and the other end is fastened to the substrate 108. The side wall may be installed on the substrate 108 by using viscose glue, or by means of welding, card fastener connection, or screw connection. The cover body is flat-shaped. The cover body is laminated to the heat sink surface of the fan-out unit 111, or the cover body is connected to the heat sink surface by using the thermally conductive adhesive. The cover body is equivalent to a structure of a flat heat sink, and is configured to conduct heat of the fan-out unit 111. The cover body and the side wall may be an integrated structure or a split structure. The cover body may be fastened to the side wall by means of tin soldering. The heat sink fin 112 shields the fan-out unit 111 on the substrate 108 for electromagnetic shielding in addition to heat dissipation. A structure of the heat sink fin 112 further helps stabilize the packaging structure and reduce a warpage possibility of the packaging structure.

In an implementation, the wiring layer 104 includes a first circuit layer, a reference layer, and a second circuit layer that are sequentially laminated. The reference layer is a reference plane for the first circuit layer and the second circuit layer. The reference layer helps improve signal quality and reduce signal crosstalk. Referring to FIG. 5 and FIG. 6, FIG. 5 and FIG. 6 each show a distribution status of the first pin array A1 and the third pin array A3 on the first chip 101, the second pin array A2 on the second chip 102, and the soldering pad 42 on the substrate 108. On this basis, FIG. 5 also shows a wiring architecture of a first circuit layer 14 of the wiring layer 104, and FIG. 6 also shows a wiring architecture of a third circuit layer 16 of the wiring layer 104. The first chip 101 is provided with first pins 32a distributed in an array manner and third pins 41 distributed in an array manner. The second chip 102 is provided with second pins 32b distributed in an array manner. The substrate 108 is provided with the soldering pad 42. The first pins 32a are connected to the second pins 32b by using the wiring layer 104. The third pins 41 are connected to the soldering pad 42 on the substrate 108 by using copper cylinders 107. The first pin array A1 on the first chip 101 includes a first group Z1 and a second group Z2, that is, the first pins 32a are divided into two groups. The second pin array A2 on the second chip 102 includes a third group Z3 and a fourth group Z4, that is, the second pins 32b are divided into two groups. The second group Z2 is electrically connected to the third group Z3 by using the first circuit layer 14 of the wiring layer 104 shown in FIG. 5, and the first group Z1 is electrically connected to the fourth group Z4 by using the third circuit layer 16 of the wiring layer 104 shown in FIG. 6. In another implementation, the wiring layer 104 may also include a third circuit layer, a fourth circuit layer, and the like; that is, the wiring layer 104 may include multiple circuit layers. A specific design is determined according to a status of an electrical signal connection between the first chip 101 and the second chip 102.

In an implementation, the intermediate board 105 is a silicon substrate, and a minimum line width and a minimum line distance of the wiring layer 104 on the intermediate board 105 may be less than or equal to 0.4 um. In another implementation, the intermediate board 105 is a fan-out substrate, and a minimum line width and a minimum line distance of the wiring layer 104 on the intermediate board 105 may be less than or equal to 2 um.

In the packaging structure in the present invention, a wiring layer 104 may be implemented on a surface of a fan-out unit 111 or a surface of an intermediate board 105 by using a layer-adding process (layer-adding is a processing process of forming a film on a die surface, and the film may be an insulator, a semiconductor, or a conductor) without a need of disposing a through-via structure. Therefore, it is easy to fabricate the wiring layer 104, and costs are low. In addition, a third pin array A3 is directly connected to a substrate 108, so that the fan-out unit 111 is connected to the substrate 108 without a need of disposing an intermediate board with a large area, and a process for fabricating a through via on an intermediate board is not required (In the prior art, wiring of electrical connection between the fan-out unit and the substrate is implemented by using a through silicon via (TSV, through silicon via) technology based on a silicon interposer, and this leads to a high process difficulty and high costs.). Therefore, the present invention has advantages of a low process difficulty and low costs. On this basis, a wiring structure of the electrical connection between the fan-out unit 111 and the substrate 108 in the present invention is also conducive to a miniaturization design of the packaging structure.

The present invention further provides a packaging method. Referring to FIG. 1 to FIG. 4, the packaging method includes the following steps.

A fan-out unit 111 is fabricated. The fan-out unit 111 includes a first chip 101 and a second chip 102. The first chip 101 includes a first pin array A1, and the second chip 102 includes a second pin array A2. The fan-out unit 111 further includes a third pin array A3. The first pin array A1, the second pin array A2, and the third pin array A3 are all disposed facing the substrate 108. Specifically, the first chip 101 and the second chip 102 are adjacently disposed, the first pin array A1 is adjacent to the second pin array A2, and the third pin array A3 is distributed in an area, other than the first pin array A1 and the second pin array A2, in the fan-out unit 111.

A wiring layer 104 is fabricated. The wiring layer 104 bridges over between the first pin array A1 and the second pin array A2, and is configured to connect each first pin in the first pin array A1 to a corresponding second pin in the second pin array A2, so as to implement electrical connection between the first chip 101 and the second chip 102.

The third pin array A3 is connected to the substrate 108, so that the fan-out unit 111 is installed on and electrically connected to the substrate 108. The substrate 108 is provided with a soldering pad 42 that is electrically connected to a wiring layer in the substrate 108 (as shown in FIG. 5 and FIG. 6). In FIG. 1 to FIG. 4, a soldering pad on the substrate 108 is located on a surface of the substrate 108 corresponding to copper cylinders 107. The third pin array A3 is electrically connected to the soldering pad 42. Specifically, the third pin array A3 is connected to the soldering pad 42 by using the copper cylinders 107.

Specifically, in an implementation of the present invention, the step of fabricating a fan-out unit 111 includes: performing, by using a molding compound, molding packaging on the first chip 101 and the second chip 102 to form the fan-out unit 111. In the present invention, only two chips are used as an example for description, and multiple chips may be integrated into the fan-out unit 111. That the first chip 101 and the second chip 102 are dies is used as an example. First, an original die is thinned in a grinding manner as required, and specific thicknesses of the first chip 101 and the second chip 102 are determined according to a product requirement and a fabrication process requirement. Then, the original die is cut to form multiple single dies. Then, reconstruction and molding compound plastic packaging are performed on a die that needs to be integrated, so as to form the fan-out unit 111. To ensure a requirement for performance of high-density interconnection between the first chip 101 and the second chip, a distance between the first chip 101 and the second chip 102 is less than or equal to 50 um. Sides of the first chip 101 and the second chip 102 are wrapped by the molding compound, and a thickness for wrapping a side by a molding compound may be flexibly designed, and is usually less than 5 mm.

Front sides of the first chip 101 and the second chip 102 form an outer surface of the fan-out unit 111. The first pin array A1, the second pin array A2, and the third pin array A3 are disposed on the front sides of the first chip 101 and the second chip 102. In an implementation, both a density of the first pin array A1 and a density of the second pin array A2 are less than a density of the third pin array A3. Referring to FIG. 5 and FIG. 6, the first pin array A1 includes multiple first pins 32a distributed in an array manner, the second pin array A2 includes multiple second pins 32b distributed in an array manner, and the third pin array A3 includes multiple third pins 41 distributed in an array manner. A size of each third pin 41 is greater than a size of each first pin 32a, the size of each third pin 41 is also greater than a size of each second pin 32b, and the size of the first pin 32a may be the same as the size of the second pin 32b.

In an implementation, the step of fabricating a wiring layer 104 specifically includes: providing an intermediate board 105, where the wiring layer 104 is a circuit layer that is fabricated on a surface of the intermediate board 105 by using a layer-adding process; and laminating the intermediate board 105 to the fan-out unit 111, so that the wiring layer 104 is electrically connected between the first pin array A1 and the second pin array A2. Specifically, a solder ball 103 is fabricated on a surface of the wiring layer 104. A quantity and sizes of the solder balls 103 are the same as a quantity and sizes of the first pins, and a quantity and sizes of the solder balls 103 are the same as a quantity and sizes of the second pins. In a process of laminating the intermediate board 105 to the fan-out unit 111, the lamination is implemented by using a hot air remelting process or a thermo-compression bonding process. The wiring layer 104 is connected between the first pin array A1 and the second pin array A2 by means of collaboration between the solder ball 103 and the first pin and collaboration between the solder ball 103 and the second pin, so as to implement connection between the first chip 101 and the second chip 102. In another implementation, the wiring layer 104 is directly fabricated on a surface of the fan-out unit 111 without using the intermediate board 105 and the solder ball 103. In the two different implementations, the wiring layer 104 may be fabricated by using a layer-adding process. A process difficulty is low, and costs are low. The wiring layer 104 is fabricated by means of passivation, sputtering, electroplating, or the like. Copper may be selected as a wiring material. A minimum line width and a minimum line distance of wiring may be less than or equal to 0.4 um.

In a process of connecting the third pin array A3 to a substrate 108, the copper cylinders 107 are first fastened at a position of a third pin correspondingly, and then the copper cylinders 107 are aligned with a corresponding soldering pad on the substrate 108. The fan-out unit 111 may be laminated to the substrate 108 by means of hot air remelting or thermo-compression bonding.

The packaging method in the present invention further includes a step of adjusting an installation height. A height difference between the fan-out unit 111 and the substrate 108 is changed by adjusting a size of a connection structure (that is, the copper cylinders 107 shown in FIG. 1 to FIG. 4) between the third pin array A3 and the substrate 108. Specifically, the height difference may be changed by increasing sizes of the copper cylinders 107 on the third pin array A3 on a side of the fan-out unit 111, or by increasing a height of the soldering pad on the substrate 108.

In another implementation, a step of adjusting the installation height may be implemented by adjusting a structure between the wiring layer 104 and the substrate 108. Specifically, a groove 1081 is disposed on the substrate 108, and the groove 1081 is disposed opposite to the wiring layer 104. The height difference between the fan-out unit 111 and the substrate 108 is changed by means of collaboration between the wiring layer 104 and the groove 1081. The disposing of the groove 1081 reduces the height difference between the fan-out unit 111 and the substrate 108. This is conducive to a miniaturization design of the packaging structure. In addition, the substrate 108 and the wiring layer 104 are isolated from each other. This isolation architecture increases signal isolation of wiring on the wiring layer 104, thereby facilitating high-density signal transmission.

Referring to FIG. 2, in an implementation of the present invention, the step of fabricating a fan-out unit 111 further includes: grinding back sides of the first chip 101 and the second chip 102 of the fan-out unit 111, so that the back sides of the first chip 101 and the second chip 102 form the outer surface of the fan-out unit 111, so as to form a heat sink surface of the fan-out unit 111. The heat sink surface is exposed, thereby facilitating heat dissipation of the packaging structure.

Referring to FIG. 3, in an implementation of the present invention, the packaging method further includes: fabricating a heat sink fin 112; and installing the heat sink fin 112 on the substrate 108, so that the heat sink fin 112 shields the fan-out unit 111 and is in contact with the heat sink surface.

Specifically, the heat sink fin 112 is made from a metallic or non-metallic thermally conductive material. A thermally conductive adhesive may be added between the heat sink fin 112 and the heat sink surface. The thermally conductive adhesive is coated on the heat sink surface, and the heat sink fin 112 is installed on the substrate 108, so that the heat sink fin 112 shields the fan-out unit 111 and is in contact with the thermally conductive adhesive.

The substrate 108 in the present invention may be a multi-layer substrate 108, and a wiring layer is disposed in the substrate 108. The fan-out unit 111 is installed on a front side of the substrate 108. A soldering pad 42 corresponding to the third pin array A3 of the fan-out unit 111 is disposed on the front side of the substrate 108 (refer to FIG. 5 and FIG. 6), and is connected between the fan-out unit 111 and the substrate 108 by using copper cylinders 107. A back side of the substrate 108 is used to connect to a circuit board in an electronic device. As shown in FIG. 1 to FIG. 4, a solder ball 109 is disposed on the back side of the substrate 108, and the packaging structure is connected to the circuit board of the electronic device by using the solder ball 109. Wiring between the first chip 101 and the second chip 102 is implemented by using the wiring layer 104, so that a quantity of wiring layers 104 on the substrate 108 may be reduced. Compared with the substrate 108, the wiring layer 104 has a smaller area and is merely used to implement the wiring between the first chip 101 and the second chip 102 without a need of fabricating more wiring layers 104 on the substrate 108 with a large area. Therefore, costs of the packaging structure may be reduced.

The foregoing descriptions are preferred implementations of the present invention. It should be noted that a person of ordinary skill in the art may make certain improvements and polishing without departing from the principle of the present invention, and the improvements and polishing shall fall within the protection scope of the present invention.

## Claims

1. A packaging structure, comprising a substrate, a fan-out unit, and a wiring layer, wherein the fan-out unit comprises a first chip and a second chip, the first chip comprises a first pin array, the second chip comprises a second pin array, the fan-out unit further comprises a third pin array, the first pin array, the second pin array, and the third pin array are all disposed facing the substrate, the first pin array comprises multiple first pins, the second pin array comprises multiple second pins, and the third pin array comprises multiple third pins; the wiring layer bridges over between the first pin array and the second pin array, and is configured to connect each first pin in the first pin array to a corresponding second pin in the second pin array, so as to implement electrical connection between the first chip and the second chip; and the substrate is provided with a soldering pad that is electrically connected to a wiring layer in the substrate, and the third pins are connected to the soldering pad, so as to implement electrical connection between the fan-out unit and the substrate.

2. The packaging structure according to claim 1, wherein the packaging structure further comprises an intermediate board disposed between the fan-out unit and the substrate, and the wiring layer is formed on a surface of the intermediate board.

3. The packaging structure according to claim 2, wherein a material of the intermediate board is silicon, glass, or an organic substrate.

4. The packaging structure according to claim 2 or 3, wherein the intermediate board and the substrate are isolated from each other.

5. The packaging structure according to claim 1, wherein the wiring layer is formed on surfaces that are of the first pin array and the second pin array and that face the substrate.

6. The packaging structure according to any one of claims 1 to 5, wherein the wiring layer comprises a first circuit layer, a reference layer, and a second circuit layer that are sequentially laminated, and the reference layer is a reference plane for the first circuit layer and the second circuit layer.

7. The packaging structure according to any one of claims 1 to 6, wherein a surface of the first chip and a surface of the second chip form a heat sink surface of the fan-out unit, and the heat sink surface is located on a surface that is of the fan-out unit and that is far away from the substrate.

8. The packaging structure according to claim 7, wherein the packaging structure further comprises a heat sink fin, the heat sink fin shields the fan-out unit on the substrate, and the heat sink fin is in contact with the heat sink surface.

9. The packaging structure according to claim 7, wherein the packaging structure further comprises a heat sink fin and a thermally conductive adhesive, the heat sink fin shields the fan-out unit on the substrate, and the thermally conductive adhesive is disposed between the heat sink surface and the heat sink fin.

10. The packaging structure according to any one of claims 1 to 9, wherein the first chip and the second chip are adjacently disposed, the first pin array and the second pin array are adjacently disposed, and the third pin array is located in an area, other than the first pin array and the second pin array, in the fan-out unit.

11. An electronic device, wherein the electronic device comprises the packaging structure according to any one of claims 1 to 10.

12. A packaging method, comprising:
fabricating a fan-out unit, wherein the fan-out unit comprises a first chip and a second chip, the first chip comprises a first pin array, the second chip comprises a second pin array, the fan-out unit further comprises a third pin array, the first pin array comprises multiple first pins, the second pin array comprises multiple second pins, and the third pin array comprises multiple third pins;
fabricating a wiring layer, wherein the wiring layer bridges over between the first pin array and the second pin array, and is configured to connect each first pin in the first pin array to a corresponding second pin in the second pin array, so as to implement electrical connection between the first chip and the second chip; and
connecting the third pin array to a substrate, wherein the substrate is provided with a soldering pad that is electrically connected to a wiring layer in the substrate, and the third pins are connected to the soldering pad, so that the fan-out unit is installed on and electrically connected to the substrate.

13. The packaging method according to claim 12, wherein the step of fabricating a fan-out unit comprises: performing, by using a molding compound, molding packaging on the first chip and the second chip to form the fan-out unit, wherein a distance between the first chip and the second chip is less than or equal to 50 um, sides of the first chip and the second chip are wrapped by the molding compound, front sides of the first chip and the second chip form an outer surface of the fan-out unit, the first pin array and the second pin array are respectively disposed on the front side of the first chip and the front side of the second chip, the first pin array is adjacent to the second pin array, and the third pin array is located in an area, other than the first pin array and the second pin array, in the fan-out unit.

14. The packaging method according to claim 13, wherein the step of fabricating a fan-out unit further comprises: grinding back sides of the first chip and the second chip of the fan-out unit, so that the back sides of the first chip and the second chip form the outer surface of the fan-out unit, so as to form a heat sink surface of the fan-out unit.

15. The packaging method according to claim 14, further comprising: fabricating a heat sink fin; and installing the heat sink fin on the substrate, so that the heat sink fin shields the fan-out unit and is in contact with the heat sink surface.

16. The packaging method according to claim 14, further comprising: fabricating a heat sink fin; coating a thermally conductive adhesive on the heat sink surface; and installing the heat sink fin on the substrate, so that the heat sink fin shields the fan-out unit and is in contact with the thermally conductive adhesive.

17. The packaging method according to any one of claims 12 to 16, further comprising: providing an intermediate board, wherein the wiring layer is a circuit layer that is fabricated on a surface of the intermediate board by using a layer-adding process; and
laminating the intermediate board to the fan-out unit, so that the wiring layer connects the first pins in the first pin array to the corresponding second pins in the second pin array.

18. The packaging method according to any one of claims 12 to 17, wherein in a process of connecting the third pin array to a substrate, the packaging method further comprises a step of adjusting an installation height, wherein a height difference between the fan-out unit and the substrate is changed by adjusting a size of a connection structure between the third pin array and the substrate.

19. The packaging method according to any one of claims 12 to 18, wherein in the process of connecting the third pin array to a substrate, the packaging method further comprises a step of adjusting the installation height, wherein a groove is disposed on the substrate, and the groove is disposed opposite to the wiring layer, so as to change the height difference between the fan-out unit and the substrate by means of collaboration between the wiring layer and the groove.
